Europäisches Patentamt

European Patent Office

Office européen des brevets

(19)

(11) Veröffentlichungsnummer: **0 008 008**
**B1**

(12)  # EUROPÄISCHE PATENTSCHRIFT

(45) Veröffentlichungstag der Patentschrift:
12.01.83

(51) Int. Cl.³: **H 01 L 29/743**

(21) Anmeldenummer: 79102392.2

(22) Anmeldetag: 11.07.79

(54) Thyristor.

(30) Priorität: 10.08.78 DE 2835089

(43) Veröffentlichungstag der Anmeldung:
20.02.80 Patentblatt 80/4

(45) Bekanntmachung des Hinweises auf die Patenterteilung:
12.01.83 Patentblatt 83/2

(84) Benannte Vertragsstaaten:
CH FR GB

(56) Entgegenhaltungen:
DE-A-2 012 796
DE-A-2 625 917
ELECTRONIC DESIGN, Band 4, 15. Februar 1978 New York "MOS-controlled triac combines low input power, high output power"
ELEKTRONICPRAXIS, Band 5, Nr. 7/8 5. August 1970 Würzburg H.L.D. ENG «Der Feldeffekt-Thyristor — ein neues Halbleiterbauelement»

(73) Patentinhaber: SIEMENS AKTIENGESELLSCHAFT
Berlin und München, Postfach 22 02 61,
D-8000 München 22 (DE)

(72) Erfinder: Ablassmeier, Ulrich, Dr., Edelbergerstrasse 7,
D-8961 Waltenhofen (DE)

Thyristor

Die Erfindung bezieht sich auf einen Thyristor nach dem Oberbegriff des Patentanspruchs 1.

Ein solcher Thyristor ist beispielsweise in der DE-A-2 625 917 oder in dem Buch von R. Müller «Bauelemente der Halbleiter-Elektronik», Springer-Verlag, Berlin 1973, auf den Seiten 174 und 174, insbesondere Abb. 197, beschrieben.

Bei den bekannten Thyristoren dieser Art steht die Steuerelektrode mit der vorletzten Halbleiterschicht unmittelbar in Kontakt. Dabei ergibt sich ein solch niedriger Eingangswiderstand an der Steuerelektrode, dass über diese Steuerströme von 10 mA oder mehr zugeführt werden müssen, um eine Zündung des Thyristors zu erreichen.

Der Erfindung liegt die Aufgabe zugrunde, Thyristoren der eingangs genannten Art so zu verbessern, dass sie mit möglichst niedrigen Steuerleistungen gezündet werden können. Dies wird gemäss der Erfindung durch die im kennzeichnenden Teil des Patentanspruchs 1 angeführten Massnahmen erreicht.

Der mit der Erfindung erzielbare Vorteil liegt insbesondere darin, dass sich ein einfach aufgebautes, zum Schalten grösserer Leistungen geeignetes Bauelement ergibt, das mit besonders niedrigen Steuerleistungen gezündet wird.

Aus der Zeitschrift «Electronic design» vom 15.2.1978 (Band 4), Seiten 32 ff ist eine Fünf-Schichten-Triac-Struktur bekannt, die aus zwei in eine Halbleiterschicht integrierten DMOS-Transistoren mit einem gemeinsamen Draingebiet aufgebaut ist. Die diffundierten Kanalzonen beider Transistoren sind mit Gateoxidbereichen abgedeckt, über denen ein gemeinsames Kontrollgate plaziert ist. Während das gemeinsame Draingebiet keinen äusseren Anschluss aufweist, sind das Sourcegebiet und die diffundierte Kanalzone des einen Transistors jeweils mit einem Kathodenanschluss, das Sourcegebiet und die diffundierte Kanalzone des anderen Thyristors jeweils mit einem Anodenanschluss versehen. Bei einer Ansteuerung des Triac über das isoliert angeordnete gemeinsame Kontrollgate ist nur eine Steuerleistung von wenigen pW erforderlich. Es handelt sich jedoch bei dieser Struktur um ein mit einer komplizierten Ansteuerung versehenes, aus mehreren Bauelementen funktionell integriertes Gebilde, das mit einem Thyristor nach der Erfindung nicht vergleichbar ist.

Die Erfindung wird nachfolgend anhand der Zeichnung näher erläutert. Dabei zeigt:

Fig. 1 ein erstes Ausführungsbeispiel eines n-Kanal-Thyristors nach der Erfindung,

Fig. 2 ein zweites Ausführungsbeispiel eines n-Kanal-Thyristors und

Fig. 3 die gemeinsame Anordnung mehrerer Thyristoren nach Fig. 1 in einer monolithisch integrierten Form.

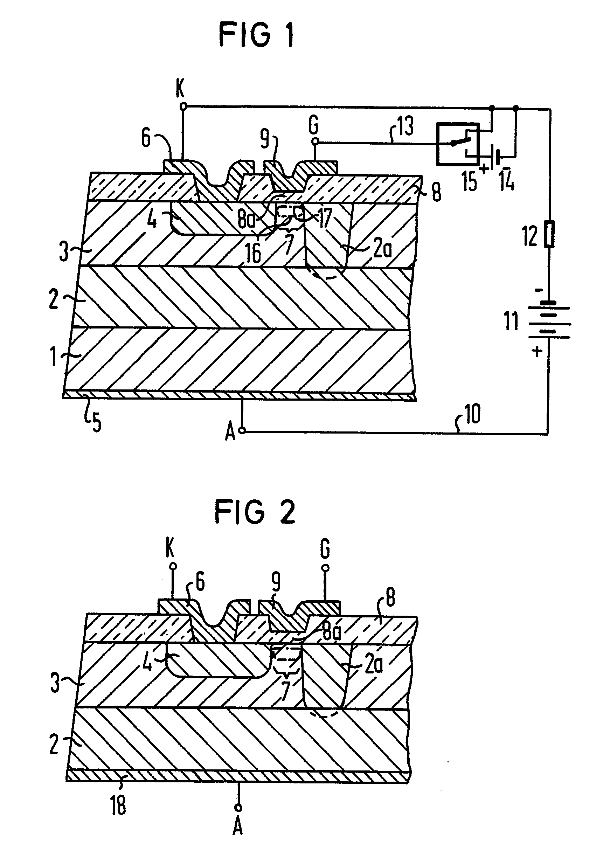

In Fig. 1 ist eine Halbleiterstruktur mit 4 übereinander liegenden Halbleiterschichten 1 bis 4 dargestellt, die jeweils aus $p^+$-, $n^-$-, $p^-$ und $n^+$-dotiertem Halbleitermaterial, z.B. Silizium, bestehen.

Die Schicht 1 wird von einer grossflächigen endseitigen Elektrode 5 kontaktiert, die die Anode des Thyristors darstellt und mit dem Anschluss A versehen ist. Die Schicht 4 wird von einer endseitigen Elektrode 6 kontaktiert, die die Kathode des Thyristors darstellt und mit einem Anschluss K verbunden ist. Die Schicht 4 überdeckt einen Teil der Oberfläche der nächstliegenden Schicht 3, der mit 7 bezeichnet ist, nicht. Dieser Teil 7 ist mit einer dünnen, elektrisch isolierenden Schicht 8a abgedeckt, auf der ein Gate 9 angeordnet ist, das mit einem Steueranschluss G verbunden ist. Im Abstand einer Kanallänge eines Feldeffekttransistors ist neben dem rechtsseitigen Rand der Schicht 4 eine denselben Leitfähigkeitstyp wie sie aufweisende, n-dotierte Zone 2a vorgesehen, die die Schicht 3 von ihrer Grenzfläche gegenüber einer die Vierschichtenstruktur abdeckenden Isolierschicht 8 bis zu ihrer Grenzfläche gegenüber der Schicht 2 durchdringt.

An die Anschlüsse A und K ist ein Stromkreis 10 geschaltet, der eine Spannungsquelle 11 und einen Lastwiderstand 12 enthält. Dabei ist der positive Pol der Spannungsquelle mit dem Anschluss A verbunden. Ein an die Anschlüsse K und G geschalteter Steuerstromkreis 13 weist eine Steuerspannungsquelle 14 und einen Umschalter 15 auf.

Wenn die von 14 erzeugte, positive, oberhalb des Wertes der Einsatzspannung liegende Steuerspannung über den Umschalter 15 in seiner nicht gezeichneten Schaltstellung an den Anschluss G geführt wird, so entsteht in der Schicht 3 eine Raumladungszone 16, innerhalb welcher sich an der Grenzfläche zur Isolierschicht 8a eine Inversionsrandschicht 17 bildet. Nach dem Aufbau dieser einen n-leitenden Kanal zwischen den Schichten 4 und der Zone 2a und damit der Schicht 2 darstellenden Inversionsrandschicht zündet der Thyristor und der zwischen den Elektroden A und K fliessende Strom schliesst den Stromkreis 10. Beim Umlegen des Umschalters 15 in seine gezeichnete Schaltstellung bleibt dieser Strom bestehen. Erst wenn der Strom einen relativ kleinen Haltewert unterschreitet, wird der Thyristor blockiert und der Stromkreis 10 wieder unterbrochen. Die vorstehend beschriebene Zündung des Thyristors erfolgt nach dem Prinzip der Anreicherung (enhancement) der Randzone der Schicht 3 mit negativen, beweglichen Ladungsträgern.

Falls die Isolierschicht 8a im Bereich ihrer Grenzfläche zu der Schicht 3 positive Grenzflächenladungen aufweist, entstehen die Raumladungszone 16 und die Inversionsrandschicht 17 in der gezeichneten Stellung des Umschalters 15, in der G auf dem Potential von K liegt. Führt man unter Umpolung der gezeichneten Spannungsquelle 14 eine negative Steuerspannung über den Umschalter 15 in seiner nicht gezeichneten Schaltstellung dem Anschluss G zu, so wird die Wirkung der Grenzflächenladungen aufgehoben und der Aufbau der Raumladungszone 16 und der Inversionsrandschicht 17 verhindert, so dass der Thyristor nicht zünden kann. Erst wenn der Umschalter 15 umgeschaltet wird und die Steuerspannung von G abschaltet, tritt die Zündung ein. Hierbei kann man von einer Zündung nach dem Prinzip der Ladungsträgerverarmung (depletion) sprechen, bei dem die Ladungsträgerdichte einer ohne angelegte Steuerspannung bestehenden Inversionsrandschicht durch das Einschalten der Steuerspannung stark verringert wird.

In Fig. 2 ist ein weiteres Ausführungsbeispiel eines n-Kanal-Thyristors nach der Erfindung dargestellt, bei dem von einer Dreischichten-Halbleiterstruktur 2,3,4 ausgegangen wird. Dabei sind die bereits anhand der Fig. 1 beschriebenen Teile mit denselben Bezugszeichen versehen. Die n-dotierte Halbleiterschicht 2 ist mit einer endseitigen, grossflächigen metallischen Belegung 18 versehen, die mit ihr eine Schottky-Diode bildet. Solche Dioden sind beispielsweise in dem Buch von R. Müller «Bauelemente der Halbleiter-Elektronik» Springer-Verlag, Berlin 1973, auf den Seiten 36 bis 41 beschrieben. Als Material für die Belegung 18 wird zweckmässigerweise Aluminium verwendet, das mit einem Zusatz von 1,5 Gewichtsprozenten Silizium versehen ist. Die Belegung 18 ist mit dem Anschluss A verbunden. Die Wirkungsweise des Thyristors nach Fig. 2 entspricht der bereits anhand von Fig. 1 beschriebenen.

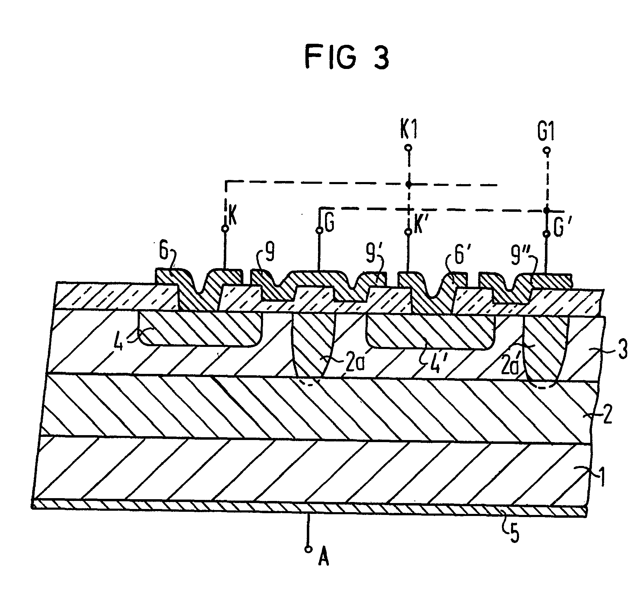

Fig. 3 zeigt zunächst zwei Thyristoren des in Fig. 1 dargestellten Typs in einer monolithisch integrierten Form. Dabei sind die in Fig. 1 beschriebenen Teile des ersten Thyristors mit denselben Bezugszeichen versehen wie oben. Der zweite Thyristor befindet sich rechts neben dem ersten, wobei die Halbleiterschichten 1 bis 3, die Zone 2a und die Elektrode 5 beiden Thyristoren gemeinsam sind. Die vierte Halbleiterschicht des zweiten Thyristors ist mit 4′bezeichnet, seine Kathode mit 6′ und der Kathodenanschluss mit K′.

Das Gate 9 des ersten Thyristors ist so weit verlängert, dass es mit seinem Teil 9′ die gleichzeitige Steuerung des zweiten Thyristors ermöglicht.

Wie in Fig. 3 weiterhin angedeutet ist, kann in Erweiterung dieses Prinzips eine ganze Reihe von Thyristoren monolithisch integriert sein, wobei der nächste sich nach rechts anschliessende Thyristor aus den Teilen K′, 6′, G′, 9″, 4′, 2a′, 3, 2, 1, 5 und A besteht. Dabei ist es zweckmässig, die Elektroden K, K′ usw. aller Thyristoren dieser Reihe mit einem gemeinsamen Kathodenanschluss K1 zu verbinden und die Gateelektroden G, G′ aller Thyristoren dieser Reihe an einen gemeinsamen Gateanschluss G1 zu führen.

Von den gemäss Fig. 2 ausgebildeten Thyristoren können ebenfalls zwei oder mehrere in einer monolithisch integrierten Form entsprechend Fig. 3 realisiert werden. Dabei ist dann die Halbleiterschicht 1 und die Elektrode 5 in Fig. 3 durch eine grossflächige metallische Belegung der Schicht 2 ersetzt, die mit dieser eine Schottky-Diode bildet.

## Patentansprüche

1. Thyristor mit mindestens drei übereinander liegenden Halbleiterschichten (1–4) unterschiedlicher Leitfähigkeitstypen, bei dem die an den Enden der Reihe liegenden Halbleiterschichten mit endseitigen, an einen Stromkreis geschalteten Elektroden (5, 6) versehen sind, bei dem die an einem Ende der Reihe liegende Halbleiterschicht (4) einen Teil der Oberfläche der angrenzenden, vorletzten Schicht (3) der Reihe nicht überdeckt, bei dem ein Bereich (7) des nicht überdeckten Teils der Oberfläche der vorletzten Schicht (3) mit einer dünnen elektrisch isolierenden Schicht (8a) abgedeckt ist, auf der ein mit einem Steueranschluss (G) verbundenes Gate (9) angeordnet ist, und bei dem im Abstand einer Kanallänge eines Feldeffekttransistors neben dem Rand der die vorletzte Schicht nicht vollständig überdeckenden Schicht (4) eine denselben Leitfähigkeitstyp wie diese aufweisende Zone (2a) angeordnet ist, dadurch gekennzeichnet, dass die Zone (2a) die vorletzte Schicht (3) bis zur Grenzfläche gegenüber der nächstfolgenden, den gleichen Leitfähigkeitstyp wie die Zone (2a) aufweisenden Schicht (2) durchdringt, so dass allein durch eine dem Gate (9) zugeführte Steuergrösse ein über die Zone (2a) verlaufender Zündstrom zwischen den endseitigen Elektroden hervorgerufen werden kann.

2. Thyristor nach Anspruch 1, dadurch gekennzeichnet, dass vier Halbleiterschichten (1–4) vorgesehen sind.

3. Thyristor nach Anspruch 1, dadurch gekennzeichnet, dass drei Halbleiterschichten (2, 3, 4) vorgesehen sind und dass die am anderen Ende der Reihe liegende Schicht (2) mit dem ihr zugeordneten endseitigen Kontakt (18) eine Schottky-Diode bildet.

4. Zwei oder mehrere Thyristoren nach einem der Ansprüche 2 oder 3, dadurch gekennzeichnet, dass ihre Halbleiterschichten mit Ausnahme der jeweils am Ende der Reihe liegenden, einen Teil der Oberfläche der vorletzten Schicht (3) freilassenden Schichten (4,4′) allen gemeinsam sind und dass jeweils zwei zueinander benachbarte Thyristoren ein gemeinsames Gate (9, 9′), eine gemeinsame Zone (2a) und einen gemeinsamen endseitigen Kontakt (5) am anderen Ende der Reihe aufweisen.

5. Zwei oder mehrere Thyristoren nach Anspruch 4, dadurch gekennzeichnet, dass sie räumlich in einer Reihe angeordnet sind, dass ihre individuell zugeordneten endseitigen Kathodenanschlüsse (K, K′) mit einem gemeinsamen Anschluss (K1) verbunden sind und dass ihre Steueranschlüsse mit einem weiteren gemeinsamen Anschluss (G1) verbunden sind.

6. Thyristor nach einem der Ansprüche 1 bis 5, dadurch gekennzeichnet, dass der Steueranschluss (G) mit einer einschaltbaren Steuerspannungsquelle (14) verbunden ist, die eine die vorletzte Schicht (3) invertierende Steuerspannung erzeugt.

7. Thyristor nach einem der Ansprüche 1 bis 5, dadurch gekennzeichnet, dass der Steueranschluss (G) mit einer einschaltbaren Steuerspannungsquelle (14) verbunden ist, die eine Steuerspannung erzeugt, welche eine unter dem Einfluss von in der dünnen Isolierschicht (8a) an der Grenzfläche zu der vorletzten Schicht (3) vorhandenen Grenzflächenladungen in der vorletzten Schicht (3) aufgebaute Inversionsrandschicht (17) beseitigt.

## Claims

1. A thyristor having at least three superimposed semiconductor layers (1–4) of different conductivity types, in which the semiconductor layers which are arranged at the ends of the series, are provided with end face electrodes (5, 6) connected in an electric circuit, in which the semiconductor layer (4), which is arranged at one end of the series, does not cover a section of the surface of the adjoining, penultimate layer (3), in which an area (7) of the non-covered section of the surface of the penultimate layer (3) is covered with a thin, electrically insulating layer (8a) on which a gate (9) connected to a control terminal (G) is arranged, and in which at the distance of the channel length of a field effect transistor adjacent to the edge of the layer (4) which does not completely cover the penultimate layer, there is arranged a zone (2a) having the same conductivity type as said layer (4), characterised in that the zone (2a) penetrates the penultimate layer (3) up to the interface with the following layer (2) which has the same conductivity type as the zone (2a), so that an ignition current running by way of the zone (2a) can be produced between the end electrodes merely by means of control value supplied to the gate (9).

2. A thyristor as claimed in claim 1, characterised in that four semiconductor layers (1–4) are provided.

3. A thyristor as claimed in claim 1, characterised in that three semiconductor layers (2, 3, 4) are provided, and that the layer (2), which is arranged at the other end of the series, forms a Schottky diode with its assigned end-face contact (18).

4. Two or more thyristors as claimed in one of claims 2 and 3, characterised in that their semiconductor layers, with the exception of the layers (4, 4') which are respectively arranged at the end of the series and leave a section of the surface of the penultimate layer (3) exposed, are common to all the thyristors, and that two thyristors which are adjacent to one another in each case have a common gate (9, 9'), a common zone (2a) and a common end face contact (5) at the other end of the series.

5. Two or more thyristors as claimed in claim 4, characterised in that they are spatially arranged in a row, that their individually assigned end face cathode terminals (K, K') are connected to a common terminal (K1) and that their control terminals are connected to a further common terminal (G1).

6. A thyristor as claimed in one of claims 1 to 5, characterised in that the control terminal (G) is switchably connected to a control voltage source (14) which produces a control voltage causing inversion of the penultimate layer (3).

7. A thyristor as claimed in one of claims 1 to 5, characterised in that the control terminal (G) is switchably connected to a control voltage source (14) and produces a control voltage which removes an inversion border layer (17) established under the influence of boundary charges which are present in the thin insulating layer (8a) at the interface with the penultimate layer (3).

## Revendications

1. Thyristor comportant au moins trois couches semiconductrices superposées (1–4) possédant des types de conduction différents, dans lequel les couches semiconductrices se trouvant aux extrémités de la série sont munies d'électrodes d'extrémité (5, 6) reliées à un circuit de courant, dans lequel la couche semiconductrice (4) se trouvant à une extrémité de la série ne recouvre pas une partie de la surface de l'avant-dernière couche voisine (3) de la série, dans lequel une région (7) de la partie non recouverte de la surface de l'avant-dernière couche (3) est recouverte par une mince couche isolante du point de vue électrique (8a), sur laquelle est disposée une grille (9) reliée à une borne de commande (G), et dans lequel à une certaine distance d'une longueur de canal d'un transistor à effet de champ, à côté du bord de la couche (4) ne recouvrant pas complètement l'avant-dernière couche, est disposée une zone (2a) possédant le même type de conductivité que celle-ci, caractérisé par le fait que la zone (2a) traverse l'avant-dernière couche (3) jusqu'à la surface limite par rapport à la couche suivante (2) présentant le même type de conductivité que la zone (2a), de sorte qu'un courant d'amorçage passant par la zone (2a) entre les électrodes d'extrémité peut être provoqué uniquement par une grandeur de commande appliquée sur la grille (9).

2. Thyristor suivant la revendication 1, caractérisé par le fait que sont prévues quatre couches semiconductrices (1–4).

3. Thyristor suivant la revendication 1, caractérisé par le fait que sont prévues trois couches semiconductrices (2, 3, 4), et que la couche (2) se trouvant à l'autre extrémité de la série forme une diode Schottky avec le contact d'extrémité (18) qui lui est associé.

4. Deux ou plusieurs transistors suivant l'une des revendications 2 ou 3, caractérisés par le fait que leurs couches semiconductrices sont toutes communes à l'exclusion des couches (4, 4') laissant libre une partie de la surface de l'avant-dernière couche (3), se trouvant respectivement à l'extrémité de la série, et que respectivement deux thyristors voisins possèdent une grille commune (9, 9'), une zone commune (2a), et un contact d'extrémité commun (5) à l'autre extrémité de la série.

5. Deux ou plusieurs transistors suivant la revendication 4, caractérisés par le fait qu'ils sont disposés suivant une série dans l'espace, que leurs bornes de cathodes d'extrémité (K, K') qui leur sont associées individuellement sont reliées à une borne commune (K1), et que leurs bornes de commande sont reliées à une autre borne commune (G1).

6. Thyristor suivant l'une des revendications 1 à 5, caractérisé en ce que la borne de commande (G) est reliée à une source de tension de commande (14) pouvant être mise en circuit, qui produit une tension de commande inversant l'avant-dernière couche (3).

7. Thyristor suivant l'une des revendications 1 à 5, caractérisé en ce que la borne de commande (G) est reliée à une source de tension de commande (14) pouvant être mise en circuit, qui produit une tension de commande qui fait disparaître une couche marginale d'inversion (17) établie dans l'avant-dernière couche (3) sous l'action des charges interfaciales existant dans la mince couche isolante (8a) au niveau de la surface limite avec l'avant-dernière couche (3).

# FIG 1

# FIG 2

# FIG 3